# EUROPEAN PATENT APPLICATION

(11) **EP 4 459 662 A1**
(43) Date of publication of application: **06.11.2024**
(21) Application number: 21970017.6
(22) Date of filing: 28.12.2021
(51) Int. Cl.: H01L 21/302, H01L 21/31, H01L 21/316, H01L 21/318

(54) **SUBSTRATE PROCESSING METHOD, PRODUCTION METHOD FOR SEMICONDUCTOR DEVICE, SUBSTRATE PROCESSING DEVICE, AND PROGRAM**

(71) Applicant: Kokusai Electric Corporation, Tokyo 101-0045 (JP)
(72) Inventor: HARADA, Katsuyoshi, Toyama-shi, Toyama 939-2393 (JP); UENO, Ryota, Toyama-shi, Toyama 939-2393 (JP); HASHIMOTO, Yoshitomo, Toyama-shi, Toyama 939-2393 (JP); NAKATANI, Kimihiko, Toyama-shi, Toyama 939-2393 (JP)
(74) Representative: Bardehle Pagenberg Partnerschaft mbB Patentanwälte Rechtsanwälte
(86) International application number: PCT/JP2021/048896
(87) International publication number: WO 2023/127137

(57) **Abstract**

A technology of the present disclosure includes performing: (a) a step for supplying a first film-forming agent on a substrate having a concave portion provided on a surface thereof, to form a first film in the concave portion; (b) a step for supplying a second film-forming agent to the substrate to form, on the first film formed in the concave portion, a second film having a chemical composition different from that of the first film; (c) a step for supplying a modifying agent containing fluorine on the substrate to modify a part of the second film; and (d) a step for supplying an etching agent containing a halogen to the substrate to remove the modified portion of the second film.

## Description

### BACKGROUND

### Technical Field

The present disclosure relates to a method of processing a substrate, a method of manufacturing a semiconductor device, a substrate processing apparatus, and a program.

### Description of the Related Art

As one step of a manufacturing step of a semiconductor device, a step of supplying a source to a substrate on a surface of which a concave portion such as a trench or a hole is provided to form a film in the concave portion may be performed (refer to, for example, WO 2019/003662).

### SUMMARY

Some embodiments of the present disclosure provide a technique capable of forming a film in a concave portion provided on a surface of a substrate with high accuracy.

According to one embodiment of the present disclosure, provided is a technology of performing:
(a) forming a first film in a concave portion by supplying a first film-forming agent to a substrate on a surface of which the concave portion is provided;
(b) forming a second film having a chemical composition different from a chemical composition of the first film on the first film formed in the concave portion by supplying a second film-forming agent to the substrate;
(c) modifying a part of the second film by supplying a modifying agent containing fluorine to the substrate; and
(d) removing a modified portion of the second film by supplying an etching agent containing halogen to the substrate.

### Effects

According to the present disclosure, it becomes possible to form a film in a concave portion provided on a surface of a substrate with high accuracy.

### BRIEF DESCRIPTION OF DRAWINGS

FIG. 1 is a schematic configuration diagram of a vertical processing furnace of a substrate processing apparatus suitably used in one embodiment of the present disclosure, and is a longitudinal cross-sectional view of a portion of a processing furnace 202.
FIG. 2 is a schematic configuration diagram of the vertical processing furnace of the substrate processing apparatus suitably used in one embodiment of the present disclosure, and is a cross-sectional view of a portion of the processing furnace 202 taken along line A-A in FIG. 1.
FIG. 3 is a schematic configuration diagram of a controller 121 of the substrate processing apparatus suitably used in one embodiment of the present disclosure, and is a block diagram illustrating a control system of the controller 121.
FIG. 4 is a flowchart illustrating a processing sequence in one embodiment of the present disclosure.

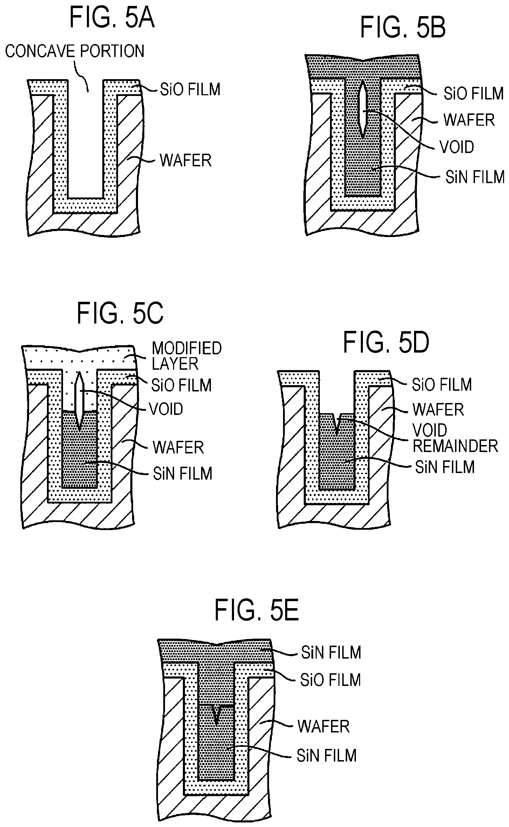

FIG. 5A is a schematic cross-sectional view illustrating a wafer surface portion after a silicon oxide film (SiO film) as a first film is formed in a concave portion by supplying a first film-forming agent to a wafer on a surface of which the concave portion is provided. FIG. 5B is a schematic cross-sectional view illustrating the wafer surface portion after a silicon nitride film (SiN film) as a second film including a void is formed on the SiO film formed in the concave portion by supplying a second film-forming agent to the wafer in a state in FIG. 5A. FIG. 5C is a schematic cross-sectional view illustrating the wafer surface portion after a part of the SiN film including a void is modified by supplying a modifying agent containing fluorine (F) to the wafer in a state of FIG. 5B. FIG. 5D is a cross-sectional view illustrating the wafer surface portion after removing a modified portion (modified layer) of the SiN film by supplying an etching agent containing halogen to the wafer in a state of FIG. 5C. FIG. 5E is a schematic cross-sectional view illustrating the wafer surface portion after the SiN film as a third film is formed on the SiN film after removing the modified layer by supplying a third film-forming agent to the wafer in a state in FIG. 5D.

### DETAILED DESCRIPTION

### <One Embodiment of the Present Disclosure>

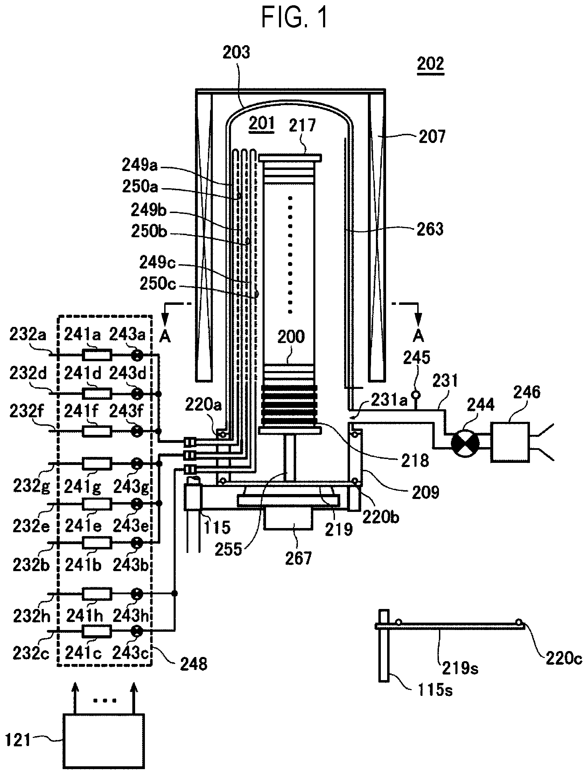

One embodiment of the present disclosure will be hereinafter described mainly with reference to FIGS. 1 to 3, FIG. 4, and FIGS. 5A to 5E. Note that, the drawings used in the following description are all schematic, and dimensional relationships between elements, ratios between elements and the like illustrated in the drawings do not necessarily coincide with actual ones. Dimensional relationships between elements, ratios between elements and the like do not necessarily coincide between a plurality of drawings, too.

### (1) Configuration of Substrate Processing Apparatus

As illustrated in FIG. 1, a processing furnace 202 includes a heater 207 as a temperature regulator (heater). The heater 207 has a cylindrical shape and is supported by a holding plate to be vertically installed. The heater 207 also serves as an activator (exciter) that thermally activates (excites) a gas.

Inside the heater 207, a reaction tube 203 is disposed concentrically with the heater 207. The reaction tube 203 is formed of, for example, a heat-resistant material such as quartz (SiO2) or silicon carbide (SiC), and is formed into a cylindrical shape with an upper end closed and a lower end opened. A manifold 209 is disposed below the reaction tube 203 concentrically with the reaction tube 203. The manifold 209 is formed of a metal material such as stainless steel (SUS), for example, into a cylindrical shape with an upper end and lower end opened. The upper end of the manifold 209 engages with the lower end of the reaction tube 203 so as to support the reaction tube 203. An O-ring 220a as a seal is provided between the manifold 209 and the reaction tube 203. The reaction tube 203 is vertically installed similarly to the heater 207. A processing container (reaction container) mainly includes the reaction tube 203 and the manifold 209. A processing chamber 201 is formed in a cylinder hollow portion of the processing container. The processing chamber 201 is formed to be able to accommodate a wafer 200 as a substrate. The wafer 200 is processed in the processing chamber 201.

In the processing chamber 201, nozzles 249a to 249c as first to third suppliers, respectively, are provided so as to penetrate a side wall of the manifold 209. The nozzles 249a to 249c are also referred to as first to third nozzles, respectively. The nozzles 249a to 249c are each formed of, for example, a heat-resistant material such as quartz or SiC. Gas supply pipes 232a to 232c are connected to the nozzles 249a to 249c, respectively. The nozzles 249a to 249c are nozzles different from one another, and the nozzles 249a and 249c are provided adjacent to the nozzle 249b.

The gas supply pipes 232a to 232c are provided with mass flow controllers (MFCs) 241a to 241c as flow rate controllers (flow rate controllers), and valves 243a to 243c as opening/closing valves, respectively, in this order from an upstream side of a gas flow. Gas supply pipes 232d and 232f are connected to the gas supply pipe 232a on a downstream side of the valve 243a. Gas supply pipes 232e and 232g are connected to the gas supply pipe 232b on a downstream side of the valve 243b. A gas supply pipe 232h is connected to the gas supply pipe 232c on a downstream side of the valve 243c. The gas supply pipes 232d to 232h are provided with MFCs 241d to 241h and valves 243d to 243h, respectively, in this order from the upstream side of the gas flow. The gas supply pipes 232a to 232h are each formed of, for example, a metal material such as SUS.

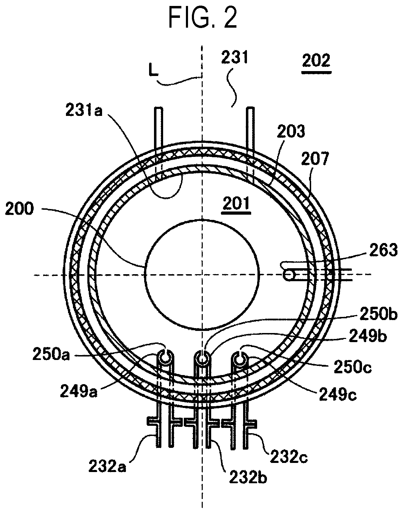

As illustrated in FIG. 2, the nozzles 249a to 249c are provided in an annular space in a plan view between an inner wall of the reaction tube 203 and the wafer 200 so as to extend upward in an arrangement direction of the wafers 200 along the inner wall of the reaction tube 203 from a lower portion to an upper portion. That is, the nozzles 249a to 249c are provided along a wafer arrangement region, in a region horizontally surrounding the wafer arrangement region, on a side of the wafer arrangement region in which the wafers 200 are arranged. In a plan view, the nozzle 249b is disposed so as to be opposed to an exhaust port 231a to be described later on a straight line across the center of the wafer 200 loaded into the processing chamber 201. The nozzles 249a and 249c are arranged so as to interpose a straight line L passing through the nozzle 249b and the center of the exhaust port 231a from both sides along the inner wall of the reaction tube 203 (outer peripheral portion of the wafer 200). The straight line L passes through the nozzle 249b and the center of the wafer 200. That is, it can also be said that the nozzle 249c is provided on a side opposite to the nozzle 249a across the straight line L. The nozzles 249a and 249c are arranged in line symmetry with the straight line L as a symmetry axis. On side surfaces of the nozzles 249a to 249c, gas supply holes 250a to 250c through which a gas is supplied are formed, respectively. The gas supply holes 250a to 250c are each opened so as to be opposed to (face) the exhaust port 231a in a plan view, and can supply a gas toward the wafer 200. A plurality of gas supply holes 250a to 250c is formed from the lower portion to the upper portion of the reaction tube 203.

A source (source gas) is supplied from the gas supply pipe 232a into the processing chamber 201 via the MFC 241a, the valve 243a, and the nozzle 249a. The source is used as one of first film-forming agents, one of second film-forming agents, and one of third film-forming agents. Note that, in a case where the source is used as the first film-forming agent, the second film-forming agent, and the third film-forming agent, this can also be referred to as a first source (first source gas), a second source (second source gas), and a third source (third source gas), respectively.

A first reactant (first reactant gas) is supplied from the gas supply pipe 232b into the processing chamber 201 via the MFC 241b, the valve 243b, and the nozzle 249b. The first reactant is used as one of the first film-forming agents.

A second reactant (second reactant gas) is supplied from the gas supply pipe 232c into the processing chamber 201 via the MFC 241c, the valve 243c, and the nozzle 249c. The second reactant is used as one of the second film-forming agents, and is used as one of the third film-forming agents. Note that, in a case where the second reactant is used as the second film-forming agent and the third film-forming agent, this can also be referred to as a second reactant (second reactant gas) and a third reactant (third reactant gas), respectively.

A modifying agent (modifying gas) is supplied from the gas supply pipe 232d into the processing chamber 201 via the MFC 241d, the valve 243d, the gas supply pipe 232a, and the nozzle 249a.

An etching agent (etching gas) is supplied from the gas supply pipe 232e into the processing chamber 201 via the MFC 241e, the valve 243e, and the nozzle 249b.

An inert gas is supplied from the gas supply pipes 232f to 232h into the processing chamber 201 via the MFCs 241f to 241h, the valves 243f to 243h, the gas supply pipes 232a to 232c, and the nozzles 249a to 249c, respectively. The inert gas acts as a purge gas, a carrier gas, a diluent gas and the like.

A source supply system (source gas supply system) mainly includes the gas supply pipe 232a, the MFC 241a, and the valve 243a. A first reactant supply system (first reactant gas supply system) mainly includes the gas supply pipe 232b, the MFC 241b, and the valve 243b. A second reactant supply system (second reactant gas supply system) mainly includes the gas supply pipe 232c, the MFC 241c, and the valve 243c. A modifying agent supply system (modifying gas supply system) mainly includes the gas supply pipe 232d, the MFC 241d, and the valve 243d. An etching agent supply system (etching gas supply system) mainly includes the gas supply pipe 232e, the MFC 241e, and the valve 243e. An inert gas supply system mainly includes the gas supply pipes 232f to 232h, the MFCs 241f to 241h, and the valves 243f to 243h.

Each or all of the source supply system and the first reactant supply system is also referred to as a first film-forming agent supply system. Each or all of the source supply system and the second reactant supply system is also referred to as a second film-forming agent supply system or a third film-forming agent.

Any one or all of the various supply systems described above may be formed as an integrated supply system 248 in which the valves 243a to 243h, the MFCs 241a to 241h and the like are integrated. The integrated supply system 248 is connected to each of the gas supply pipes 232a to 232h, and is configured such that a supplying operation of various substances (various gases) into the gas supply pipes 232a to 232h, that is, an opening/closing operation of the valves 243a to 243h, a flow rate regulating operation by the MFCs 241a to 241h and the like are controlled by a controller 121 to be described later. The integrated supply system 248 is formed as an integral or separable integrated unit, and can be attached to or detached from the gas supply pipes 232a to 232h and the like on an integrated unit basis, so that the integrated supply system 248 can be maintained, replaced, or added on an integrated unit basis.

The exhaust port 231a from which an atmosphere inside the processing chamber 201 is exhausted is formed in a lower portion of a side wall of the reaction tube 203. As illustrated in FIG. 2, the exhaust port 231a is provided at a position opposed to (facing) the nozzles 249a to 249c (gas supply holes 250a to 250c) across the wafer 200 in a plan view. The exhaust port 231a may be provided along the side wall of the reaction tube 203 from the lower portion toward the upper portion, that is, along the wafer arrangement region. An exhaust pipe 231 is connected to the exhaust port 231a. A vacuum pump 246 as a vacuum exhauster is connected to the exhaust pipe 231 via a pressure sensor 245 as a pressure detector (pressure detector) that detects a pressure in the processing chamber 201 and an auto pressure controller (APC) valve 244 as a pressure regulator (pressure regulator). The APC valve 244 is configured to be able to perform vacuum exhaust and stop the vacuum exhaust inside the processing chamber 201 by opening/closing the valve in a state in which the vacuum pump 246 is operated, and to be able to regulate the pressure in the processing chamber 201 by regulating a degree of valve opening on the basis of pressure information detected by the pressure sensor 245 in a state in which the vacuum pump 246 is activated. An exhaust system mainly includes the exhaust pipe 231, the APC valve 244, and the pressure sensor 245. The vacuum pump 246 may also be included in the exhaust system.

A seal cap 219 as a furnace opening lid capable of hermetically closing the lower end opening of the manifold 209 is provided below the manifold 209. The seal cap 219 is formed of, for example, a metal material such as SUS into a disk shape. An O-ring 220b as a seal that abuts the lower end of the manifold 209 is provided on an upper surface of the seal cap 219. A rotator 267 that rotates a boat 217 to be described later is disposed below the seal cap 219. A rotating shaft 255 of the rotator 267 penetrates the seal cap 219 and is connected to the boat 217. The rotator 267 is configured to rotate the boat 217, thereby rotating the wafer 200. A boat elevator 115 as an elevator disposed outside the reaction tube 203 is configured to vertically raise and lower the seal cap 219. The boat elevator 115 is formed as a carrier (carrier) that loads and unloads (carry) the wafer 200 into and from the processing chamber 201 by raising and lowering the seal cap 219.

Below the manifold 209, a shutter 219s as a furnace opening lid capable of hermetically closing the lower end opening of the manifold 209 in a state in which the seal cap 219 is lowered and the boat 217 is unloaded from the inside of the processing chamber 201 is provided. The shutter 219s is formed of, for example, a metal material such as SUS into a disk shape. An O-ring 220c as a seal that abuts the lower end of the manifold 209 is provided on an upper surface of the shutter 219s. An opening/closing operation (elevating operation, rotating operation and the like) of the shutter 219s is controlled by a shutter opener/closer 115s.

The boat 217 as a substrate support is configured to support a plurality of, for example, 25 to 200 wafers 200 horizontally, in multiple stages so as to be aligned vertically with the centers aligned with one another, that is, to arrange at intervals. The boat 217 is formed of, for example, a heat-resistant material such as quartz or SiC. Heat insulating plates 218 each formed of, for example, a heat-resistant material such as quartz or SiC are supported in multiple stages in a lower portion of the boat 217.

A temperature sensor 263 as a temperature detector is disposed in the reaction tube 203. By regulating a degree of energization to the heater 207 on the basis of temperature information detected by the temperature sensor 263, a desired temperature distribution can be achieved in the processing chamber 201. The temperature sensor 263 is disposed along the inner wall of the reaction tube 203.

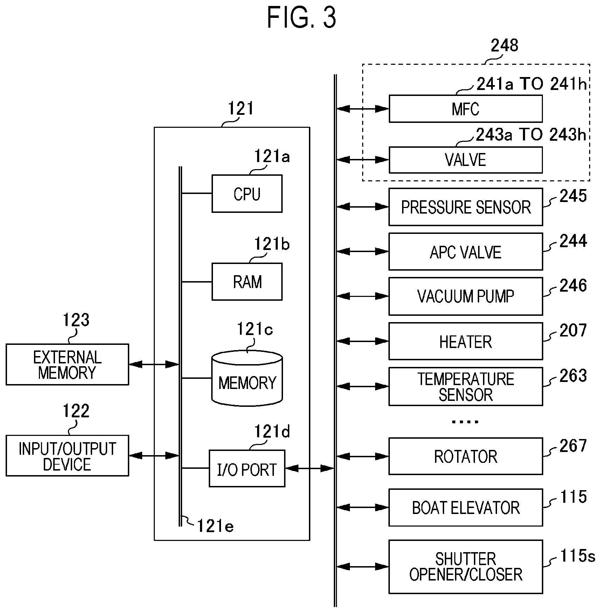

As illustrated in FIG. 3, a controller 121 as a controller (controller) is formed as a computer including a central processing unit (CPU) 121a, a random access memory (RAM) 121b, a memory 121c, and an I/O port 121d. The RAM 121b, the memory 121c, and the I/O port 121d are configured to be able to exchange data with the CPU 121a via an internal bus 121e. An input/output device 122 formed as, for example, a touch panel and the like is connected to the controller 121. An external memory 123 can be connected to the controller 121.

The memory 121c includes, for example, a flash memory, a hard disk drive (HDD), a solid state drive (SSD) and the like. A control program for controlling an operation of the substrate processing apparatus, a process recipe in which procedures, conditions and the like of substrate processing to be described later are described and the like are readably stored in the memory 121c. The process recipe is a combination that allows the controller 121 to allow the substrate processing apparatus to execute each procedure in the substrate processing to be described later to obtain a predetermined result, and serves as a program. Hereinafter, the process recipe, the control program and the like are collectively and simply referred to as a program. The process recipe is simply referred to as a recipe. In a case where the term "program" is used in the present specification, this may include the recipe alone, the control program alone, or both of them. The RAM 121b is formed as a memory area (work area) in which programs, data and the like read by the CPU 121a are temporarily stored.

The I/O port 121d is connected to the MFCs 241a to 241h, the valves 243a to 243h, the pressure sensor 245, the APC valve 244, the vacuum pump 246, the temperature sensor 263, the heater 207, the rotator 267, the boat elevator 115, the shutter opener/closer 115s and the like described above.

The CPU 121a is configured to be able to read the control program from the memory 121c and execute the same, and read the recipe from the memory 121c in response to an input and the like of an operation command from the input/output device 122. The CPU 121a is configured to be able to control, in accordance with a content of the read recipe, a flow rate regulating operation of various substances (various gases) by the MFCs 241a to 241h, an opening/closing operation of the valves 243a to 243h, a pressure regulating operation by the APC valve 244 based on an opening/closing operation of the APC valve 244 and the pressure sensor 245, start and stop of the vacuum pump 246, a temperature regulating operation of the heater 207 based on the temperature sensor 263, rotation and rotating speed regulating operation rotation of the boat 217 by the rotator 267, an elevating operation of the boat 217 by the boat elevator 115, an opening/closing operation of the shutter 219s by the shutter opener/closer 115s and the like.

The controller 121 can be formed by installing the above-described program stored in the external memory 123 into the computer. Examples of the external memory 123 include, for example, a magnetic disk such as an HDD, an optical disk such as a CD, a magneto-optical disk such as an MO, a semiconductor memory such as a USB memory or an SSD and the like. The memory 121c and the external memory 123 are formed as computer-readable recording media. Hereinafter, they are collectively and simply referred to as recording media. In a case where the term "recording medium" is used in the present specification, this may include the memory 121c alone, the external memory 123 alone, or both of them. Note that, the program may be provided to the computer not by using the external memory 123 but by using a communication means such as the Internet or a dedicated line.

### (2) Substrate Processing Step

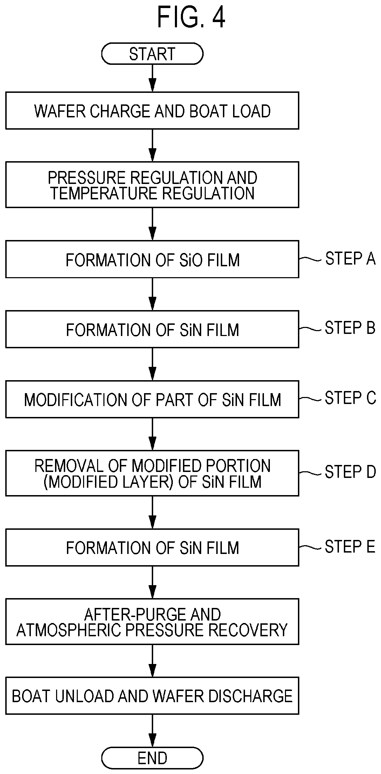

An example of a processing sequence for forming a film in a concave portion such as a trench and a hole provided on the surface of the wafer 200 as the substrate is described mainly with reference to FIGS. 4 and 5A to 5E as a step of a manufacturing step of the semiconductor device using the above-described substrate processing apparatus. In the following description, a case where a SiO film that is an oxide film is formed as a first film and a SiN film that is a film other than the SiO film is formed as a second film and a third film will be described. In the following description, an operation of each unit included in the substrate processing apparatus is controlled by the controller 121.

As illustrated in FIGS. 4 and 5A to 5E, the processing sequence in the present embodiment includes:
(a) step A of forming the first film (SiO film) in the concave portion by supplying the first film-forming agent to the wafer 200 on the surface of which the concave portion is provided,
(b) step B of forming the second film (SiN film) having a chemical composition different from that of the first film (SiO film) on the first film (SiO film) formed in the concave portion by supplying the second film-forming agent to the wafer 200,
(c) step C of modifying a part of the second film (SiN film) by supplying the modifying agent containing fluorine to the wafer 200,
(d) step D of removing a modified portion of the second film (SiN film) by supplying the etching agent containing halogen to the wafer 200, and
(e) step E of forming the third film (SiN film) on the second film (SiN film) obtained after removing the modified portion by supplying the third film-forming agent to the wafer 200.

In the present specification, the above-described processing sequence may be expressed as follows for convenience. A similar expression will be used in the following description of variations and other embodiments.
Step A → step B → step C → step D → step E

The expression "having a different chemical composition" used in the present specification means that at least a part of the elements forming a film, a layer, and a site (for example, the concave portion provided on the surface of the wafer) is different. For example, in a case of describing the second film having the chemical composition different from that of the first film, this means that at least a part of elements forming the respective films is different, such as the SiO film as the first film and the SiN film as the second film.

The term "wafer" used in the present specification may mean the wafer itself, or a laminate of the wafer and a predetermined layer or film formed on the surface thereof. The phrase "surface of the wafer" used in the present specification may mean the surface of the wafer itself or the surface of a predetermined layer and the like formed on the wafer. The expression "forming a predetermined layer on the wafer" in the present specification may mean that a predetermined layer is directly formed on the surface of the wafer itself or that a predetermined layer is formed on a layer and the like formed on the wafer. In a case where the term "substrate" is used in the present specification, this is a synonym of the term "wafer".

The term "agent" used in the present specification includes at least one of a gaseous substance and a liquid substance. The liquid substance includes a mist substance. That is, the first film-forming agent (source, first reactant), the second film-forming agent (source, second reactant), the third film-forming agent (source, second reactant), the modifying agent, and the etching agent may each include the gaseous substance, the liquid substance such as the mist substance, or both of them.

The term "layer" used in the present specification includes at least one of a continuous layer and a discontinuous layer. For example, a Si-containing layer and a modified layer to be described later may include the continuous layer, the discontinuous layer, or both of them.

### (Wafer Charge and Boat Load)

When a plurality of wafers 200 is loaded on the boat 217 (wafer charge), the shutter opener/closer 115s moves the shutter 219s, and the lower end opening of the manifold 209 is opened (shutter open). Thereafter, as illustrated in FIG. 1, the boat 217 that supports the plurality of wafers 200 is raised by the boat elevator 115 and is loaded into the processing chamber 201 (boat load). In this state, the lower end of the manifold 209 is sealed by the seal cap 219 via the O-ring 220b. In this manner, the wafers 200 are prepared in the processing chamber 201.

Note that, as illustrated in FIG. 5A, a trench-shaped or hole-shaped concave portion is provided on the surface of the wafer 200 loaded on the boat 217. The surface of the concave portion provided on the wafer 200 is formed of a material having a chemical composition different from that of the SiO film as the first film, that is, a material other than the SiO film, for example, silicon (Si).

### (Pressure Regulation and Temperature Regulation)

After the boat load is finished, the inside of the processing chamber 201, that is, a space in which the wafer 200 is present is vacuum-exhausted (decompression-exhausted) by the vacuum pump 246 so as to achieve a desired pressure (vacuum degree). At that time, the pressure in the processing chamber 201 is measured by the pressure sensor 245, and the APC valve 244 is feedback-controlled on the basis of information of the measured pressure. The heater 207 heats in such a manner that the wafer 200 in the processing chamber 201 reaches desired processing temperature. In this case, on the basis of the temperature information detected by the temperature sensor 263, the degree of energization to the heater 207 is feedback-controlled in such a manner that a desired temperature distribution is obtained in the processing chamber 201. The rotator 267 starts to rotate the wafer 200. The exhaust in the processing chamber 201, the heating and the rotation of the wafer 200 continue at least until the processing on the wafer 200 is finished.

### (Step A)

Thereafter, step A is executed. At step A, the first film-forming agent is supplied to the wafer 200 in the processing chamber 201, that is, the wafer 200 provided with the concave portion on the surface, thereby forming the SiO film as the first film in the concave portion. At this step, as illustrated in FIG. 5A, the SiO film is formed in the concave portion with a thickness to leave an opening of the concave portion so that the SiN film can be formed in the concave portion at step B to be performed later. Note that, at this step, as illustrated in FIG. 5A, the SiO film is formed also on the surface (upper surface) of the wafer 200 other than the concave portion.

At this step, for example, the SiO film is formed by performing a cycle of alternately performing step A1 of supplying the source to the wafer 200 and step A2 of supplying the first reactant to the wafer 200 a predetermined number of times (m times, m is an integer of 1 or larger). Hereinafter, a method for forming the SiO film including steps A1 and A2 will be specifically described. Note that, in the following example, the first film-forming agent contains the source and the first reactant.

### [Step A1]

At step A1, the source (source gas) is supplied to the wafer 200 in the processing chamber 201 as the first film-forming agent.

Specifically, the valve 243a is opened to allow the source to flow into the gas supply pipe 232a. The source that flows through the gas supply pipe 232a is regulated in flow rate by the MFC 241a, supplied into the processing chamber 201 via the nozzle 249a, and exhausted from the exhaust port 231a. At that time, the source is supplied to the wafer 200 from the side of the wafer 200. At that time, the valves 243f to 243h may be opened to supply the inert gas into the processing chamber 201 via the nozzles 249a to 249c, respectively.

Processing conditions when supplying the source at step A1 are exemplified as follows:
processing temperature: 400 to 700 degrees C, preferably 500 to 650 degrees C,
processing pressure: 1 to 2,666 Pa, preferably 67 to 1,333 Pa,
source supply flow rate: 0.01 to 2 slm, preferably 0.1 to 1 slm,
source supply time: 1 to 120 seconds, preferably 1 to 60 seconds, and
inert gas supply flow rate (each gas supply pipe): 0 to 10 slm.

Note that, in the present specification, the expression of a numerical range such as "400 to 700 degrees C" means that a lower limit value and an upper limit value are included in the range. Therefore, for example, "400 to 700 degrees C" means "equal to higher than 400 degrees C and equal to lower than 700 degrees C". The same applies to other numerical ranges. In the present specification, the processing temperature means the temperature of the wafer 200 or the temperature in the processing chamber 201, and the processing pressure means the pressure in the processing chamber 201. A processing time means a time in which the processing is continued. In a case where 0 slm is included in the supply flow rate, "0 slm" means a case where the substance (gas) is not supplied. The same applies to the following description.

By supplying, for example, a chlorosilane-based gas containing Si and chloride (Cl) to the wafer 200 as the source under the above-described processing conditions, a Si-containing layer containing Cl is formed on an inner surface of the concave portion of the wafer 200. The Si-containing layer containing Cl is formed by physical adsorption or chemical adsorption of the source, chemical adsorption of a substance obtained by decomposition of a part of the source, deposition of Si by thermal decomposition of the source and the like on the inner surface of the concave portion of the wafer 200. The Si-containing layer containing Cl may be an adsorption layer (a physical adsorption layer or a chemical adsorption layer) of the source and the substance obtained by the decomposition of a part of the source, or may be a deposition layer of Si containing Cl. In the present specification, the Si-containing layer containing Cl is also simply referred to as a Si-containing layer.

After the Si-containing layer is formed, the valve 243a is closed to stop supplying the source into the processing chamber 201. Then, the inside of the processing chamber 201 is vacuum-exhausted to remove the gas and the like remaining in the processing chamber 201 from the inside of the processing chamber 201. At that time, the valves 243f to 243h are opened to supply the inert gas into the processing chamber 201 via the nozzles 249a to 249c. The inert gas supplied into the processing chamber 201 acts as a purge gas, so that the inside of the processing chamber 201 is purged (purge).

As the source (source gas), which is one of the first film-forming agents, for example, a silane-based gas containing Si, which is a main element forming the SiO film formed on the inner surface of the concave portion, can be used. As the silane-based gas, for example, a gas containing Si and a halogen element, that is, a halosilane-based gas can be used. Halogen includes chlorine (Cl), fluorine (F), bromine (Br), iodine (I) and the like.

As the halosilane-based gas, for example, a chlorosilane-based gas such as a monochlorosilane (SiH₃Cl, abbreviated as MCS) gas, a dichlorosilane (SiH₂Cl₂, abbreviated as DCS) gas, a trichlorosilane (SiHCl₃, abbreviated as TCS) gas, a tetrachlorosilane (SiCl₄, abbreviated as 4CS) gas, a hexachlorodisilane gas (Si₂Cl₆, abbreviated as HCDS) gas, and an octachlorotrisilane (Si₃Cl₈, abbreviated as OCTS) gas; a fluorosilane-based gas such as a tetrafluorosilane (SiF₄) gas and a difluorosilane (SiH₂F₂) gas, a bromosilane-based gas such as a tetrabromosilane (SiBr₄) gas and a dibromosilane (SiH₂Br₂) gas, and an iodosilane-based gas such as a tetraiodosilane (SiI₄) gas and a diiodosilane (SiH₂I₂) gas can be used. As the halosilane-based gas, for example, an alkylenechlorosilane-based gas such as a bis(trichlorosilyl)methane ((SiCl₃)₂CH₂, abbreviated as BTCSM) gas or a 1,2-bis(trichlorosilyl)ethane ((SiCl₃)₂C₂H₄, abbreviated as BTCSE) gas; an alkylchlorosilane-based gas such as a 1,1,2,2-tetrachloro-1,2-dimethyldisilane ((CH₃)₂Si₂Cl₄, abbreviated as TCDMDS) gas or a 1,2-dichloro-1,1,2,2-tetramethyldisilane (CH₃)₄Si₂Cl₂, abbreviated as DCTMDS) gas; or a gas containing a cyclic structure composed of Si and C such as a 1,1,3,3-tetrachloro-1,3-disilacyclobutane (C₂H₄Cl₄Si₂, abbreviated as TCDSCB) gas and a halogen can also be used. One or more of them can be used as the source.

As the source, for example, a gas containing Si and hydrogen (H), that is, a silicon hydride gas can also be used. As the silicon hydride gas, for example, a monosilane (SiH₄) gas, a disilane (Si₂H6) gas, a trisilane (Si₃H₈) gas, and a tetrasilane (Si₄H₁₀) gas can be used. One or more of them can be used as the source.

As the source, for example, a gas containing Si and an amino group, that is, an aminosilane-based gas can also be used. The amino group can be represented as -NH₂, -NHR, - NR₂. Here, R represents an alkyl group, and two R's in -NR₂ may be the same or different.

As the aminosilane-based gas, for example, a tetrakis(dimethylamino)silane (Si[N(CH₃)₂]₄, abbreviated as 4DMAS) gas, a tris(dimethylamino)silane (Si[N(CH₃)₂]₃H, abbreviated as 3DMAS) gas, a bis(diethylamino)silane (Si[N(C₂H₅)₂]₂H₂, abbreviated as BDEAS) gas, a bis(tertiarybutylamino)silane (SiH₂[NH(C₄H₉)]₂, abbreviated as BTBAS) gas, or a (diisopropylamino)silane (SiH₃[N(C₃H₇)₂], abbreviated as DIPAS) gas can also be used. One or more of them can be used as the source.

As the inert gas, for example, a rare gas such as a nitrogen (N₂) gas, an argon (Ar) gas, a helium (He) gas, a neon (Ne) gas, or a xenon (Xe) gas can be used. One or more of them can be used as the inert gas. The same applies to each step described later.

### [Step A2]

After step A1 is finished, the first reactant (first reactant gas) is supplied as the first film-forming agent to the wafer 200 in the processing chamber 201, that is, the wafer 200 with the Si-containing layer formed on the inner surface of the concave portion thereof.

Specifically, the valve 243b is opened to allow the first reactant to flow into the gas supply pipe 232b. The first reactant that flows through the gas supply pipe 232b is regulated in flow rate by the MFC 241b, supplied into the processing chamber 201 via the nozzle 249b, and exhausted from the exhaust port 231a. At that time, the first reactant is supplied to the wafer 200 from the side of the wafer 200. At that time, the inert gas may be supplied into the processing chamber 201 via each of the nozzles 249a to 249c.

Processing conditions when supplying the first reactant at step A2 are exemplified as follows:
processing temperature: 400 to 700 degrees C, preferably 500 to 650 degrees C,
processing pressure: 1 to 2000 Pa, preferably 1 to 1,000 Pa,
first reactant (oxidizing agent, O-containing gas) supply flow rate: 0.1 to 10 slm,
first reactant (reducing gas (H-containing gas)) supply flow rate: 0 to 10 slm,
inert gas supply flow rate (each gas supply pipe): 0 to 10 slm, and
each gas supply time: 1 to 120 seconds, preferably 1 to 60 seconds.

By supplying an oxidizing agent, for example, as the first reactant to the wafer 200 under the above-described conditions, at least a part of the Si-containing layer formed on the inner surface of the concave portion of the wafer 200 is oxidized (modified). As a result, a SiO layer is formed as a layer containing Si and O on the inner surface of the concave portion of the wafer 200. When the SiO layer is formed, impurities such as Cl contained in the Si-containing layer form a gaseous substance containing at least Cl in the process of a modifying reaction (oxidizing reaction) of the Si-containing layer by the first reactant, and are discharged from the inside of the processing chamber 201. Accordingly, the SiO layer becomes a layer containing fewer impurities such as Cl than the Si-containing layer formed at step A1.

After the SiO layer is formed, the valve 243b is closed to stop supplying the first reactant into the processing chamber 201. Then, the gas and the like remaining in the processing chamber 201 are removed from the inside of the processing chamber 201 by processing procedures similar to the purge at step A1 (purge).

For example, an oxidizing agent (oxidizing gas) can be used as the first reactant (first reactant gas) as one of the first film-forming agents. Note that, the oxidizing agent can be used not only by being thermally excited in a non-plasma atmosphere but also by being plasma-excited. That is, as the oxidizing agent, an oxidizing agent excited to a plasma state can also be used.

As the oxidizing agent, for example, an oxygen (O)-containing gas such as an oxygen (O₂) gas and an ozone (O₃) gas, an O- and H-containing gas such as water vapor (H₂O gas) and a hydrogen peroxide (H₂O₂) gas, an O- and N-containing gas such as a nitrous oxide (N₂O) gas, a nitric oxide (NO) gas, and a nitrogen dioxide (NO₂) gas, and an O- and C-containing gas such as a carbon oxide (CO) gas and a carbon dioxide gas (CO₂) can be used. As the oxidizing agent, a mixed gas of the O-containing gas and the reducing gas described above can also be used.
Here, the reducing gas is a substance that cannot obtain an oxidizing action by itself, but reacts with the O-containing gas under specific conditions, for example, the above-described processing conditions to generate oxidizing species such as atomic oxygen, and acts to improve efficiency of oxidizing. For example, a H-containing gas such as a hydrogen (H₂) gas and a heavy hydrogen (²H₂) gas can be used as the reducing gas. That is, as the oxidizing agent, for example, an O₂ gas + H₂ gas, an O₃ gas + H₂ gas and the like can be used. One or more of them can be used as the first reactant.

In the present specification, the description of two gases such as "H₂ gas + O₂ gas" means a mixed gas of H₂ gas and O₂ gas. In a case of supplying the mixed gas, the two gases may be mixed (premixed) in the supply pipe and then supplied into the processing chamber 201, or the two gases may be separately supplied into the processing chamber 201 from different supply pipes and mixed (post-mixed) in the processing chamber 201.

### [Predetermined Number of Times of Execution]

When a cycle of alternately, that is, not simultaneously performing steps A1 and A2 described above is performed a predetermined number of times (m times: m is an integer of 1 or larger), a SiO film can be formed as the first film on the inner surface of the concave portion of the wafer 200 as illustrated in FIG. 5A. The cycle described above is preferably repeated a plurality of times. That is, it is preferable to make the SiO layer formed per cycle thinner than a desired thickness of film and repeat the above-described cycle a plurality of times until the thickness of the SiO film formed by stacking the SiO layer becomes the desired thickness.

Note that, at this step, the SiO film may be formed by a chemical vapor deposition method (CVD method) in which the source and the first reactant are simultaneously supplied. For example, at this step, the SiO film may be formed in the concave portion by the CVD method by simultaneously supplying the source and the first reactant to the wafer 200 under the processing conditions similar to the processing conditions at steps A1 and A2 described above. In this case, the thickness of film of the SiO film can be regulated by the supply time of the source and the first reactant. Note that, the supply time of the source and the first reactant may be made longer than the supply time of the source and the first reactant under the processing conditions at steps A1 and A2 described above. As the source and the first reactant used in this method, the source and the first reactant similar to various sources and first reactants exemplified at steps A1 and A2 described above can be used.

At this step, the SiO film may be formed on the inner surface of the concave portion by oxidizing the surface of the concave portion formed of Si by thermal oxidation such as dry oxidation, wet oxidation, and reduced pressure oxidation, plasma oxidation, ozone oxidation and the like. For example, at this step, the SiO film may be formed on the inner surface of the concave portion by oxidizing the inner surface of the concave portion by performing step A2 described above alone on the wafer 200 under the processing conditions similar to the processing conditions at step A2 described above. In this case, the thickness of film of the SiO film can be regulated by the supply time of the first reactant. Note that, the supply time of the first reactant may be made longer than the supply time of the first reactant under the processing conditions at step A2 described above. In this method, it is sufficient that the first film-forming agent contains the first reactant. As the first reactant used in this method, the first reactant similar to various first reactants exemplified at step A2 described above can be used.

The thickness of the SiO film formed in the concave portion at this step is preferably 5 nm or more, and more preferably 10 nm or more in the thinnest part of the SiO film. When the thickness of the SiO film is made less than 5 nm, a function as a modification stopper to be described later might be insufficient. By setting the thickness of the SiO film to 5 nm or more, the function as the modification stopper can be sufficiently obtained. By setting the thickness of the SiO film to 10 nm or more, the function as the modification stopper can be more sufficiently obtained.

The thickness of the SiO film formed in the concave portion at this step is preferably a thickness with which the opening of the concave portion is not filled, that is, a thickness with which the opening of the concave portion is left. For example, when the concave portion has a cylindrical shape, the thickness of the SiO film formed in the concave portion is preferably less than half the diameter of the opening of the concave portion. This is because it is difficult to form the SiN film as the second film if the opening of the concave portion is filled with the SiO film.

An upper limit of the thickness of the SiO film formed in the concave portion may be determined according to the size of the opening of the concave portion; this is, for example, preferably 30 nm or less, more preferably 20 nm or less, and still more preferably 15 nm or less. When the thickness of the SiO film is made more than 30 nm, the opening of the concave portion is narrowed, and filling characteristics with the SiN film might not be sufficiently obtained. By setting the thickness of the SiO film to 30 nm or less, this problem can be solved. By setting the thickness of the SiO film to 20 nm or less, this problem can be sufficiently solved. By setting the thickness of the SiO film to 15 nm or less, this problem can be more sufficiently solved.

From the above, the thickness of the SiO film formed in the concave portion at this step is preferably 5 nm to 30 nm, more preferably 5 nm to 20 nm, still more preferably 5 nm to 15 nm, and particularly preferably 10 nm to 15 nm.

The SiO film formed at this step has low reactivity with the modifying agent used at step C to be performed later, and has etching resistance higher than that of the modified layer formed at step C to be performed later.

### (Step B)

After step A is finished, step B is executed. At this step, the second film-forming agent is supplied to the wafer 200 in the processing chamber 201, thereby forming the SiN film as the second film on the SiO film as the first film formed in the concave portion at step A. At this step, the SiN film, which is a film containing Si and nitrogen (N), is formed as the second film with a thickness that fills the concave portion on the inner surface of which the SiO film is formed. At that time, as illustrated in FIG. 5B, the opening of the concave portion is closed by the SiN film, and a portion (a space generated by a void or a seam) not filled with the SiN film is formed in the concave portion. That is, the SiN film formed so as to fill the concave portion has a space (gap, hollow portion) in the film. Note that, at this step, as illustrated in FIG. 5B, the SiN film is formed also on the SiO film formed on the surface (upper surface) of the wafer 200 other than the concave portion.

At this step, for example, the SiN film is formed by performing a cycle of alternately performing step B1 of supplying the source to the wafer 200 and step B2 of supplying the second reactant to the wafer 200 a predetermined number of times (n times, n is an integer of 1 or larger). Hereinafter, a method for forming the SiN film including steps B1 and B2 will be specifically described. Note that, in the following example, the second film-forming agent contains the source and the second reactant.

### [Step B1]

At step B1, the source (source gas) is supplied to the wafer 200 in the processing chamber 201, that is, to the wafer 200 with the SiO film formed on the inner surface of the concave portion thereof as the second film-forming agent. This step can be performed by the processing procedure similar to that at step A1 described above and under the following processing conditions. At this step, the Si-containing layer can be formed on the SiO film. After forming the Si-containing layer, the gas and the like remaining in the processing chamber 201 are removed from the inside of the processing chamber 201 by processing procedures similar to the purge at step A1 described above (purge). As the source, for example, the source similar to the various sources exemplified at step A1 described above can be used.

Processing conditions when supplying the source at step B1 are exemplified as follows:
processing temperature: 400 to 800 degrees C, preferably 500 to 650 degrees C,
processing pressure: 1 to 2,666 Pa, preferably 67 to 1333 Pa,
source supply flow rate: 0.01 to 2 slm, preferably 0.1 to 1 slm,
source supply time: 1 to 120 seconds, preferably 1 to 60 seconds, and
inert gas supply flow rate (each gas supply pipe): 0 to 10 slm.

### [Step B2]

After step B1 is finished, the second reactant (second reactant gas) is supplied as the second film-forming agent to the wafer 200 in the processing chamber 201, that is, to the wafer 200 with the Si-containing layer formed on the SiO film formed on the inner surface of the concave portion thereof.

Specifically, the valve 243c is opened to allow the second reactant to flow through the gas supply pipe 232c. The second reactant that flows through the gas supply pipe 232c is regulated in flow rate by the MFC 241c, supplied into the processing chamber 201 via the nozzle 249c, and exhausted from the exhaust port 231a. At that time, the second reactant is supplied to the wafer 200 from the side of the wafer 200. At that time, the inert gas may be supplied into the processing chamber 201 via each of the nozzles 249a to 249c.

Processing conditions when supplying the second reactant at step B2 are exemplified as follows:
processing temperature: 400 to 800 degrees C, preferably 500 to 650 degrees C,
processing pressure: 1 to 4,000 Pa, preferably 1 to 3,000 Pa,
second reactant supply flow rate: 0.1 to 10 slm,
second reactant supply time: 1 to 120 seconds, preferably 1 to 60 seconds, and
inert gas supply flow rate (each gas supply pipe): 0 to 10 slm.

For example, by supplying a nitriding agent (nitriding gas) as the second reactant to the wafer 200 under the above-described processing conditions, at least a part of the Si-containing layer is nitrided (modified). As a result, a SiN layer is formed as a layer containing Si and N on the SiO film formed on the inner surface of the concave portion of the wafer 200. When the SiN layer is formed, impurities such as Cl contained in the Si-containing layer form a gaseous substance containing at least Cl in the process of the modifying reaction (nitriding reaction) of the Si-containing layer by the second reactant, and are discharged from the inside of the processing chamber 201. Accordingly, the SiN layer becomes a layer containing fewer impurities such as Cl than the Si-containing layer formed at step B1.

After the SiN layer is formed, the valve 243c is closed to stop supplying the second reactant into the processing chamber 201. Then, the gas and the like remaining in the processing chamber 201 are removed from the inside of the processing chamber 201 by processing procedures similar to the purge at step A1 (purge).

For example, a nitriding agent (nitriding gas) can be used as the second reactant (second reactant gas) as one of the second film-forming agents. Note that, the nitriding agent can be used not only by being thermally excited in a non-plasma atmosphere but also by being plasma-excited. That is, as the nitriding agent, a nitriding agent excited to a plasma state can also be used.

As the nitriding agent, for example, a nitride (N)-containing gas can be used. As the N-containing gas, a N- and H-containing gas can be used. As the N- and H-containing gas, a hydrogen nitride-based gas such as an ammonia (NH₃) gas, a diazene (N₂H₂) gas, a hydrazine (N₂H₄) gas, or a N₃H₈ gas can be used, for example. As the N- and H-containing gas, for example, a C-, N-, and H-containing gas can be used. As the C-, N-, and H-containing gas, for example, an ethylamine-based gas such as a monoethylamine (C₂H₅NH₂, abbreviated as MEA) gas, a diethylamine ((C₂H₅)₂NH, abbreviated as DEA) gas, and a triethylamine ((C₂H₅)₃N, abbreviated as TEA) gas, a methylamine-based gas such as a monomethylamine (CH₃NH₂, abbreviated as MMA) gas, a dimethylamine ((CH₃)₂NH, abbreviated as DMA) gas, and a trimethylamine ((CH₃)₃N, abbreviated as TMA) gas, and an organic hydrazine-based gas such as a monomethylhydrazine ((CH₃)HN₂H₂, abbreviated as MMH) gas, a dimethylhydrazine ((CH₃)₂N₂H₂, abbreviated as DMH) gas, and a trimethylhydrazine ((CH₃)₂N₂(CH₃)H, abbreviated as TMH) gas can be used. One or more of them can be used as the second reactant. Note that, in a case where the second reactant containing C, such as an amine-based gas or an organic hydrazine-based gas is used, a SiN layer containing C can be formed at step B2.

### [Predetermined Number of Times of Execution]

When a cycle of alternately, that is, not simultaneously performing steps B 1 and B2 described above is performed a predetermined number of times (n times: n is an integer of 1 or larger), the concave portion of the wafer 200 may be filled with the SiN film as the second film as illustrated in FIG. 5B. The cycle described above is preferably repeated a plurality of times. That is, it is preferable to make the SiN layer formed per cycle thinner than a desired thickness of film and repeat the above-described cycle a plurality of times until the thickness of the SiN film formed by stacking the SiN layer becomes a thickness to fill the concave portion of the wafer 200.

Note that, at this step, the SiN film may be formed by a CVD method in which the source and the second reactant are simultaneously supplied. For example, at this step, the SiN film may be formed in the concave portion by the CVD method by simultaneously supplying the source and the second reactant to the wafer 200 under the processing conditions similar to the processing conditions at steps B1 and B2 described above. In this case, the thickness of film of the SiN film can be regulated by the supply time of the source and the second reactant. Note that, the supply time of the source and the second reactant may be made longer than the supply time of the source and the second reactant under the processing conditions at steps B 1 and B2 described above. As the source and the second reactant used in this method, the source and the second reactant similar to various sources exemplified at step A1 described above and various second reactants exemplified at step B2 described above can be used.

### (Step C)

After step B is finished, step C is executed. At this step, the modifying agent containing F is supplied to the wafer 200 in the processing chamber 201 to modify a part of the SiN film. Specifically, at this step, a part of the surface side of the SiN film as the second film formed at step B is modified to a F-containing layer, particularly a F-containing SiO layer or a SiOF layer as the F- and O-containing layer. The F-containing SiO layer or the SiOF layer is also referred to as a Si-, F-, and O-containing layer. Since the F-containing SiO layer or the SiOF layer is a modified portion of the SiN film, this is hereinafter also referred to as a modified layer for convenience. At this step, as illustrated in FIG. 5C, in the concave portion of the wafer 200, the modified layer is formed (stacked) on the SiN film maintained without being modified with the SiO film as a base. Note that, at this step, as illustrated in FIG. 5C, the SiN film formed on the surface (upper surface) of the wafer 200 other than the concave portion is modified to the modified layer.

Specifically, the valve 243d is opened to allow the modifying agent to flow into the gas supply pipe 232d. The modifying agent that flows through the gas supply pipe 232d is regulated in flow rate by the MFC 241d, supplied into the processing chamber 201 via the nozzle 249a, and exhausted from the exhaust port 231a. At that time, the modifying agent is supplied to the wafers 200 from the side of the wafer 200. At that time, the inert gas may be supplied into the processing chamber 201 via each of the nozzles 249a to 249c.

Processing conditions when supplying the modifying agent at step C are exemplified as follows:
processing temperature: 100 to 500 degrees C, preferably 350 to 450 degrees C,
processing pressure: 1 to 2,666 Pa, preferably 67 to 1,333 Pa,
modifying agent supply flow rate: 0.001 to 2 slm, preferably 0.002 to 1 slm,
modifying agent supply time: 30 seconds to 30 minutes, preferably 1 to 20 minutes, and
inert gas supply flow rate (each gas supply pipe): 0 to 10 slm.

By supplying the modifying agent containing F to the wafer 200 under the above-described processing conditions, a part of the SiN film with which the concave portion is filled is modified into the modified layer (F-containing SiO layer or SiOF layer). Since the modification of the SiN film to the modified layer proceeds in a depth direction from the surface of the SiN film in accordance with the supply of the modifying agent to the surface of the SiN film, the SiN film located on the surface side (upper side in FIG. 5C) of the SiN film in the concave portion is converted into the modified layer (F-containing SiO layer or SiOF layer). The thickness of the modified layer can be controlled by the supply condition of the modifying agent to the wafer 200.

At this step, the SiO film as the first film formed at step A can act as a modification suppression film. As a result, even in a case where a part of a region of the SiN film from the surface of the SiN film to a site in contact with a part of the SiO film is modified, it is possible to suppress the SiO film from being modified by the modifying agent. In other words, the SiO film formed at step A can suppress or stop the progress of the modification in the depth direction of the SiO film itself by the modifying agent. That is, the SiO film serves as a modification stopper. As a result, while this step is performed, it is possible to prevent alteration of the inner surface of the concave portion of the wafer 200, which is the base of the SiO film, and damage to the inner surface of the concave portion.

A reason why the SiO film serves as the modification stopper is that the reactivity between the modifying agent and the SiO film is lower than the reactivity between the modifying agent and the SiN film, in other words, a substance the reactivity of which with the SiO film is lower than the reactivity with the SiN film is used as the modifying agent. In other words, it can also be said that this is because the modifying agent is supplied under the processing conditions in which the reactivity between the modifying agent and the SiO film is lower than the reactivity between the modifying agent and the SiN film. By utilizing such a difference in reactivity, at this step, it is possible to selectively modify a part of the SiN film while suppressing or stopping the progress of the modification of the SiO film. Note that, depending on the processing conditions, it is possible to prevent the modifying agent and the SiO film from reacting, that is, preventing the SiO film from being modified.

From the above, at this step, the modification of the SiN film can proceed in the concave portion with directivity in the depth direction and selectively, and a modified layer having a shape as illustrated in FIG. 5C can be formed. As a result, a stacked film obtained by stacking the modified layer (F-containing SiO layer or SiOF layer) is present on the SiN film maintained without being modified with the SiO film as a base in the concave portion.

At this step, it is preferable to modify a region from the surface of the SiN film to a site in contact with at least a part of a space (void or seam) generated in the process of forming the SiN film in the SiN film. That is, at this step, it is preferable to allow the modification of the SiN film to progress to a position deeper than the upper portion of the space (void or seam) in the SiN film. For example, it is preferable to progress the modification of the SiN film to a position of at least half the depth of the space in the SiN film. For example, it is preferable that the modification of the SiN film progresses to a position deeper than half the depth of the space in the SiN film. Moreover, for example, it is preferable that the modification of the SiN film progresses to a position as deep as two-thirds of the depth or deeper of the space in the SiN film. Note that FIG. 5C illustrates an example in which the modification of the SiN film progresses to the position as deep as two-thirds of the depth or deeper of the space in the SiN film.

By allowing the modification of the SiN film to progress as described above, it is possible to eliminate at least a part of the space in the SiN film in the concave portion by removing the modified layer at step D to be performed later, and the space can be opened. As a result, the space in the concave portion can be filled with the third film formed at step E performed after step D. Note that, the modification of the SiN film can also progress to the same depth as the bottom of the space in the SiN film. In this case, the space itself in the SiN film can be eliminated by removing the modified layer at step D to be performed later.

In this manner, at this step, since the SiO film serves as the modification stopper, it is possible to selectively modify a part of the SiN film without altering the inner surface of the concave portion formed of Si and the like and without damaging the inner surface of the concave portion.

After the modified layer is formed, the valve 243d is closed to stop the supply of the modifying agent into the processing chamber 201. Then, the gas and the like remaining in the processing chamber 201 are removed from the inside of the processing chamber 201 by processing procedures similar to the purge at step A1 (purge).

As the modifying agent (modifying gas), for example, it is preferable to use a substance containing F, it is more preferable to use a substance containing F and O, and it is still more preferable to use a substance containing F, O, and N. As the modifying agent, for example, it is preferable to use a F-containing gas, it is more preferable to use a F- and O-containing gas, and it is still more preferable to use a F-, O-, and N-containing gas. That is, the modifying agent preferably contains F, more preferably contains F and O, and still more preferably contains F, O, and N. Furthermore, as the modifying agent, for example, a mixed gas of a N- and O-containing gas and a F-containing gas, a mixed gas of a F-, N-, and O-containing gas and a F-containing gas, or a F-, N-, and O-containing gas can also be used. By using such modifying agent, it is possible to modify a part of the SiN film as the second film to a layer (F-containing SiO layer or SiOF layer) that is easily removed by the etching agent.

As the modifying agent, for example, NO gas + fluorinated (F₂) gas, NO gas + chlorine monofluoride (ClF) gas, NO gas + chlorine trifluoride (ClF₃) gas, NO gas + nitrogen trifluoride (NF₃) gas, nitrosyl fluoride (FNO) gas + F₂ gas, FNO gas + CIF gas, FNO gas + ClF₃ gas, FNO gas + NF₃ gas, FNO gas and the like may be used. One or more of them are usable as the modifying agent. Note that, for example, a gas that is difficult to store such as the FNO gas is preferably generated by mixing the F₂ gas and the NO gas, for example, in the supply pipe or the nozzle, and supplied into the processing chamber 201. In this case, a mixed gas of the F₂ gas, NO gas, and FNO gas is supplied into the processing chamber 201.

### (Step D)

After step C is finished, step D is executed. At this step, the etching agent containing halogen is supplied to the wafer 200 in the processing chamber 201 to remove a modified portion (modified layer) of the SiN film. That is, at this step, at step C, a portion (modified layer) of the SiN film modified to the F-containing SiO layer or the SiOF layer is removed. At this step, as illustrated in FIG. 5D, the SiN film maintained without being modified remains in the concave portion of the wafer 200, the surface of the SiN film is exposed, and a part of the SiO film, that is, a portion in contact with the modified layer is exposed. Note that, at this step, as illustrated in FIG. 5D, the modified layer on the surface (upper surface) of the wafer 200 other than the concave portion is also removed, and the SiO film is exposed.

Specifically, the valve 243e is opened to allow the etching agent to flow through the gas supply pipe 232e. The etching agent is regulated in flow rate by the MFC 241e, supplied into the processing chamber 201 via the gas supply pipe 232b and the nozzle 249b, and exhausted from the exhaust port 231a. At that time, the etching agent is supplied to the wafers 200 from the side of the wafer 200. At that time, the inert gas may be supplied into the processing chamber 201 via each of the nozzles 249a to 249c.

Processing conditions when supplying the etching agent at step D are exemplified as follows:
processing temperature: room temperature (25 degrees C) to 600 degrees C, preferably 50 to 200°C,
processing pressure: 1 to 13,332 Pa, preferably 100 to 1,333 Pa,
etching agent supply flow rate: 0.05 to 5 slm, preferably 0.1 to 2 slm,
etching agent supply time: 0.1 to 30 minutes, preferably 1 to 10 minutes, and
inert gas supply flow rate (each gas supply pipe): 0 to 10 slm.

By supplying the etching agent to the wafer 200 under the above-described processing conditions, a modified portion of the SiN film, that is, the modified layer (F-containing SiO layer or SiOF layer) is removed. At that time, the SiO film formed at step A can act as an etching suppression film, and etching of the SiO film can be suppressed even in a case where the modified layer in contact with the SiO film is etched. That is, the SiO film can suppress or stop the progress of etching in the depth direction of the SiO film, that is, on the base side of the SiO film. That is, the SiO film serves as an etching stopper. As a result, while this step is being performed, it is possible to prevent alteration of the inner surface of the concave portion of the wafer 200, which is the base of the SiO film, and damage to the inner surface of the concave portion.

A reason why the SiO film serves as the etching stopper is that the reactivity between the etching agent and the SiO film is lower than the reactivity between the etching agent and the modified layer (F-containing SiO layer or SiOF layer), in other words, a substance the reactivity of which with the SiO film is lower than the reactivity with the modified layer is used as the etching agent. In other words, it can also be said that this is because the etching agent is supplied under the processing conditions in which the reactivity between the etching agent and the SiO film is lower than the reactivity between the etching agent and the modified layer. By utilizing such a difference in reactivity, at this step, it is possible to selectively etch the modified layer while suppressing or stopping the progress of the etching of the SiO film. Note that, the SiO film is a F-free film, whereas the modified layer is a F-containing layer. This difference in chemical composition between the SiO film and the modified layer is one of the reasons why the etching rate of the SiO film is lower than the etching rate of the modified layer, in other words, the etching resistance of the SiO film is higher than the etching resistance of the modified layer.

From the above, at this step, the etching of the portion of the SiN film modified to the F-containing SiO layer or the SiOF layer, that is, the modified layer can be allowed to selectively progress with directivity in the depth direction in the concave portion. As a result, as illustrated in FIG. 5D, the SiN film maintained without being modified remains in the concave portion with the SiO film as the base, and a portion in contact with the modified layer of the SiO film is exposed.

After the modified layer is removed and the surface of the SiN film maintained without being modified is exposed, the valve 243e is closed and supply of the etching agent into the processing chamber 201 is stopped. Then, the inside of the processing chamber 201 is vacuum-exhausted to remove the gaseous substance and the like remaining in the processing chamber 201 from the inside of the processing chamber 201. Then, by the processing procedure similar to that in the purge at step A1 described above, the gaseous substance and the like remaining in the processing chamber 201 is removed from the inside of the processing chamber 201 (purge).

As the etching agent (etching gas), it is preferable to use a halogen-containing substance, for example, a substance containing at least one of F, Cl, and I. As a result, it is possible to effectively selectively remove the modified portion (modified layer) of the SiN film as the second film while suppressing the etching of the SiO film as the first film.

As the etching agent, for example, a F₂ gas, a NF₃ gas, a ClF₃ gas, a CIF gas, a tungsten hexafluoride (WF₆) gas, an iodine heptafluoride (IF₇) gas, an iodine pentafluoride (IF₅) gas, a hexafluoroacetylacetone (C₅H₂F₆O₂) gas, a hydrogen fluoride (HF) gas, a FNO gas, a chlorine (Cl₂) gas, a hydrogen chloride (HCl) gas, a boron trichloride (BCl₃) gas, a thionyl chloride (SOCl₂) gas, a tungsten hexachloride (WCl₆) gas and the like can be used. One or more of them is usable as the etching agent.

Note that, the modifying agent used at step C and the etching agent used at step D may be the same substance (gas). For example, it is also possible to use, for example, a FNO gas as the modifying agent at step C and use, for example, a FNO gas as the etching agent at step D. In this case, by controlling the processing conditions at steps C and D, the FNO gas can act as a modifying agent at step C, and the FNO gas can act as an etching agent at step D.

### (Step E)

After step D is finished, step E is executed. At this step, the third film-forming agent is supplied to the wafer 200 in the processing chamber 201, thereby forming the SiN film as the third film on the SiN film obtained after removing the modified layer. At this step, the SiN film is formed as the third layer on the SiN film remaining in the concave portion after the modified layer is removed at step D (SiN film maintained without being modified), the SiN film formed as the third film having a thickness that fills the concave portion as illustrated in FIG. 5E. Note that, at this step, as illustrated in FIG. 5E, the SiN film is formed also on the surface of the wafer 200 other than the concave portion.

When step D is finished, the SiN film as the second film maintained without being modified remains on a bottom side in the concave portion of the wafer 200. As a result, the depth of the concave portion (trench or hole), that is, an aspect ratio is relaxed (reduced), and even if the SiN film as the third film is formed with a thickness to fill the concave portion, it is possible to fill the concave portion without generating a void or seam.

At this step, the source and the second reactant similar to those of the second film-forming agent at step B described above are used as the third film-forming agent, and the SiN film as the third film can be formed by the similar processing procedure and processing conditions as those at step B described above. As the source, for example, the source similar to the various sources exemplified at step B1 (step A1) described above can be used, and as the second reactant, the second reactant similar to the various second reactants exemplified at step B2 described above can be used.

### (After-Purge and Atmospheric Pressure Restoration)

After step E is finished, an inert gas as a purge gas is supplied from each of the nozzles 249a to 249c into the processing chamber 201 and is exhausted from the exhaust port 231a. As a result, the inside of the processing chamber 201 is purged, and a gas and a reaction by-product remaining in the processing chamber 201 are removed from the inside of the processing chamber 201 (after-purge). Thereafter, the atmosphere in the processing chamber 201 is replaced with the inert gas (inert gas replacement), so that the pressure in the processing chamber 201 is restored to a normal pressure (atmospheric pressure restoration).

### (Boat Unload and Wafer Discharge)

After that, the boat elevator 115 lowers the seal cap 219, and the lower end of the manifold 209 is opened. Then, the processed wafer 200 is unloaded from the lower end of the manifold 209 to the outside of the reaction tube 203 in a state of being supported by the boat 217 (boat unload). After the boat unload, the shutter 219s is moved, and the lower end opening of the manifold 209 is sealed by the shutter 219s via the O-ring 220c (shutter close). After being unloaded to the outside of the reaction tube 203, the processed wafer 200 is taken out from the boat 217 (wafer discharge).

Steps A, B, C, D, and E are preferably performed in the same processing chamber (in-situ). As a result, steps A, B, C, D, and E can be performed without exposing the wafer 200 to the atmosphere, that is, while maintaining the surface of the wafer 200 in a clean state.

### (3) Effects of Present Embodiment

According to the present embodiment, one or a plurality of the following effects can be obtained.

In the present embodiment, before the second film is formed in the concave portion provided on the surface of the wafer 200 at step B, the first film is formed at step A. As a result, when a part of the second film is modified at step C, the first film can act as the modification suppressing film, and when the modified portion (modified layer) of the second film is removed at step D, the first film can act as the etching suppressing film. That is, the first film formed in the concave portion before the second film is formed can be allowed to function as a modification stopper when a part of the second film is modified, and to function as an etching stopper when a modified portion (modified layer) of the second film is removed. This makes it possible to modify a part of the second film and to remove a modified portion (modified layer) of the second film without altering the inner surface of the concave portion and without damaging the inner surface of the concave portion. As a result, a film can be formed in the concave portion with high accuracy.

In the present embodiment, the third film can be formed in the concave portion including the inner surface that is not altered and is maintained in an appropriate state without being damaged at step E. As a result, a film can be formed in the concave portion with high accuracy. As a result, the concave portion can be filled with the film with high accuracy. Note that, when the material of the third film is the same as the material of the second film, the concave portion can be filled with a film of the same material. Note that, when the material of the third film is made different from the material of the second film, the concave portion can be filled with a film of the different material (stacked film).

In the present embodiment, at step A, a SiO film that is an oxide film is formed as the first film. Since the first film is the oxide film as described above, when a part of the SiN film as the second film is modified at step C, the first film can be allowed to effectively function as a modification stopper, and when the modified portion (modified layer) of the SiN film is removed at step D, the first film can be allowed to effectively function as an etching stopper. Since the first film is the SiO film, when a part of the SiN film as the second film is modified at step C, the first film can be allowed to more effectively function as a modification stopper, and when the modified portion (modified layer) of the SiN film is removed at step D, the first film can be allowed to more effectively function as an etching stopper.

In the present embodiment, at step B, a film other than the SiO film, that is, a SiN film having a chemical composition different from that of the SiO film is formed as the second film. As described above, since the second film is a film other than the SiO film, that is, a film having a chemical composition different from that of the SiO film, particularly, the SiN film, the second film can be made a film that is easily modified by the modifying agent and is hardly removed by the etching agent.

In the present embodiment, the wafer 200 in which the surface of the concave portion is formed of a material other than the SiO film, that is, Si, which is a material having a chemical composition different from that of the SiO film, is used. As described above, when the surface of the concave portion is formed of a material other than the SiO film, that is, a material having a chemical composition different from that of the SiO film, particularly, a material containing Si, the above-described effect can be more remarkably generated.

In the present embodiment, the reactivity between the modifying agent and the first film is made lower than the reactivity between the modifying agent and the second film. That is, the reactivity between the modifying agent and the second film is made higher than the reactivity between the modifying agent and the first film. As a result, at step C, it is possible to selectively modify a part of the second film while suppressing the modification of the first film.

In the present embodiment, at step C, a part of a region of the second film from a surface of the second film to a site in contact with a part of the first film is modified, and at step D, a part of the first film is exposed. At such steps C and D, it is possible to selectively modify a part of the second film while suppressing the modification of the first film, and to selectively remove the modified portion (modified layer) of the second film while suppressing the etching of the first film.

In the present embodiment, the second film includes a seam or a void, and at step C, a region of the second film from a surface of the second film to at least a site in contact with at least a part of the seam or the void is modified, and at step D, at least a part of the seam or the void is eliminated while removing the modified region (modified layer). By eliminating at least a part of the seam or the void in the second film in this manner, it is possible to fill the concave portion seamlessly and free of void.

In the present embodiment, at step C, a part of the second film is modified into a F- and O-containing layer, particularly a Si-, F-, and O-containing layer. As a result, it is possible to modify a part of the second film to a layer easily removed by the etching agent, and to effectively selectively remove the modified portion of the second film while suppressing the etching of the first film.

In the present embodiment, the reactivity between the etching agent and the first film is made lower than the reactivity between the etching agent and a modified portion (modified layer) of the second film. That is, the reactivity between the etching agent and the modified layer is made higher than the reactivity between the etching agent and the first film. As a result, it is possible to selectively remove a modified portion of the second film while suppressing the etching of the first film.

### (4) Variations

The processing sequence in the present embodiment can be modified as in the following variation. These variations can be optionally combined. Unless otherwise specifically described, processing procedures and processing conditions at each step of each of the variations can be made similar to the processing procedures and processing conditions at each step of the processing sequence described above.

### (Variation 1)

As in the following processing sequence, a cycle of step C → step D may be performed a plurality of times (y times, y is an integer of 2 or more).
Step A → step B → (step C → step D) × y→ step E

Also in the present variation, the effects similar to those in the above embodiment can be obtained. According to the present variation, even in a case where the etching amount (removal amount) of the SiN film formed at step B is insufficient after steps C and D are finished, the etching amount can be increased by performing the cycle of step C → step D a plurality of times. In this case, the etching amount can be controlled by the number of cycles (y), and controllability of the etching amount can also be improved. According to the present variation, even in such a case, it is possible to fill while controlling the etching amount, and it is possible to fill seamlessly and free of void.

### (Variation 2)

As in the following processing sequence, a cycle of step C → step D → step E may be performed a plurality of times (z times, z is an integer of 2 or more).
Step A → step B → (step C → step D → step E) × z

Also in the present variation, the effects similar to those in the above embodiment can be obtained. According to the present variation, for example, in a case where the concave portion is deep (the aspect ratio is large) and the like, even in a case where a void or a seam (space) is generated in the SiN film as the third film formed at step E, the concave portion can be filled while eliminating the void or the seam by performing the cycle of step C → step D → step E a plurality of times. According to the present variation, even in such a case, it is possible to fill seamlessly and free of void.

### (Variation 3)

The material of the third film formed at step E may be made different from the material of the second film formed at step B. When the material of the third film is made different from the material of the second film, the concave portion can be filled with a film of the different material (stacked film). In this case, the third film can be formed by using a film-forming agent (second source, second reactant) different from the second film-forming agent used at step B as the third film-forming agent (third source, third reactant) used at step E and selecting a processing procedure and processing conditions according to the material of the third film. In this case, the material of the third film can be made different from the material of the second film by making at least one of the source and the reactant different between step E and step B. In the present variation also, the film can be formed in the concave portion with high accuracy.

### <Other Embodiments of Present Disclosure>

The embodiment of the present disclosure has been specifically described above. However, the present disclosure is not limited to the above embodiment, and various modifications can be made without departing from the gist thereof.

For example, in the above-described embodiment and variations, an example in which steps A, B, C, D, and E are performed has been described, but step E in the above-described embodiment may be omitted as in the following processing sequence. For example, at step E, in a case where it is not necessary to fill the concave portion with the third film, step E can be omitted. In the present embodiment also, the film can be formed in the concave portion with high accuracy.
Step A → step B → step C → step D
Step A → step B → (step C → step D) ×y

For example, in the above-described embodiment and variations, an example in which steps A, B, C, D, and E are performed in the same processing chamber 201 (in-situ) has been described; however, at least one of steps A, B, C, D, and E may be performed in a different processing chamber (processing unit, processing space) (ex-situ). If at least one of steps A, B, C, D, and E is performed in a different processing chamber, temperature in each processing chamber can be set in advance to, for example, processing temperature at each step or temperature close thereto, a time required for temperature adjustment can be shortened, and production efficiency can be increased.

For example, in the above-described embodiment and variations, an example in which the surface of the concave portion is formed of Si has been described, but it is sufficient that the surface of the concave portion is formed of a material having a chemical composition different from that of the first film, and this may be formed of a material containing Si, for example. For example, the surface of the concave portion may be formed of at least one of monocrystal Si, a Si film, a SiN film, a silicon carbide film (SiC film), a silicon carbonitride film (SiCN film), a silicon oxycarbonitride film (SiOCN film), a silicon oxycarbide film (SiOC film), a silicon oxynitride film (SiON film), a silicon boron carbonitride film (SiBCN film), a silicon boron nitride film (SiBN film), a silicon boron carbide film (SiBC film), a silicon boron oxide film (SiBO film) and the like.

For example, in the above-described embodiment and variations, an example in which the second film and the third film are the SiN films has been described, but it is sufficient that the second film and the third film are films other than the SiO films, and may be, for example, films containing Si and N. For example, the second film and the third film may include at least one of the SiN film, SiCN film, SiOCN film, SiOCN film, SiON film, SiBCN film, and SiBN film.

Preferably, the recipe used in each processing is individually prepared according to processing contents and stored in the memory 121c via an electric communication line or the external memory 123. Then, when each processing is started, the CPU 121a preferably appropriately selects an appropriate recipe from among the plurality of recipes stored in the memory 121c according to processing contents. Accordingly, it is possible to form films with various film types, composition ratios, film qualities, and thicknesses of film with excellent reproducibility by using one substrate processing apparatus. It is possible to reduce a burden on an operator, and it is possible to quickly start each processing while avoiding an operation error.

The recipe described above is not limited to a newly created recipe, but may be prepared by, for example, changing the existing recipe already installed in the substrate processing apparatus. In a case of changing the recipe, the changed recipe may be installed in the substrate processing apparatus via an electric communication line or a recording medium in which the recipe is recorded. The existing recipe already installed in the substrate processing apparatus may be directly changed by operating the input/output device 122 included in the existing substrate processing apparatus.

In the above-described embodiment, an example has been described in which a film is formed by using a batch-type substrate processing apparatus that processes a plurality of substrates at a time. The present disclosure is not limited to the above-described embodiment, and can be suitably applied to a case of forming a film by using a single wafer type substrate processing apparatus that processes one or more substrates at a time, for example. In the above-described embodiment, an example has been described in which a film is formed by using a substrate processing apparatus including a hot wall-type processing furnace. The present disclosure is not limited to the above-described embodiment, and can be suitably applied to a case of forming a film by using a substrate processing apparatus including a cold wall-type processing furnace.

Even in cases where such substrate processing apparatuses are used, each processing can be performed in accordance with processing procedures and processing conditions similar to those in the above-described embodiment and variations, so that effects similar to those in the above-described embodiment and variations can be obtained.

The above-described embodiment and variations can be used in combination as appropriate. For example, the processing procedures and processing conditions at that time can be made similar to the processing procedures and processing conditions in the above-described embodiment and variations.

### EXPLANATION OF REFERENCE NUMERALS

200: wafer (substrate)

## Claims

1. A method of processing a substrate comprising:
(a) forming a first film in a concave portion by supplying a first film-forming agent to the substrate on a surface of which the concave portion is provided;
(b) forming a second film having a chemical composition different from a chemical composition of the first film on the first film formed in the concave portion by supplying a second film-forming agent to the substrate;
(c) modifying a part of the second film by supplying a modifying agent containing fluorine to the substrate; and
(d) removing a modified portion of the second film by supplying an etching agent containing halogen to the substrate.

2. The method according to claim 1, further comprising:
(e) forming a third film on the second film after removing the modified portion by supplying a third film-forming agent to the substrate.

3. The method according to claim 1, wherein the first film is an oxide film.

4. The method according to claim 1, wherein the first film is a silicon oxide film.

5. The method according to claim 1, wherein the second film is a film other than a silicon oxide film.

6. The method according to claim 1, wherein the second film contains silicon and nitrogen.

7. The method according to claim 1, wherein a surface of the concave portion is formed of a material other than a silicon oxide film.

8. The method according to claim 1, wherein a surface of the concave portion is formed of a material containing silicon.

9. The method according to claim 1, wherein the modifying agent contains fluorine and oxygen.

10. The method according to claim 1, wherein the modifying agent contains fluorine, nitrogen, and oxygen.

11. The method according to claim 1, wherein the modifying agent is a mixed gas of a nitrogen- and oxygen-containing gas and a fluorine-containing gas, a mixed gas of a fluorine-, nitrogen-, and oxygen-containing gas and a fluorine-containing gas, or a fluorine-, nitrogen-, and oxygen-containing gas.

12. The method according to claim 1, wherein reactivity between the modifying agent and the first film is lower than reactivity between the modifying agent and the second film.

13. The method according to claim 1, wherein in (c), a part of a region of the second film from a surface of the second film to a site in contact with a part of the first film is modified, and
wherein in (d), a part of the first film is exposed.

14. The method according to claim 1, wherein the second film includes a seam or a void,
wherein in (c), a region of the second film from a surface of the second film to at least a site in contact with at least a part of the seam or the void is modified, and
wherein in (d), at least a part of the seam or the void is eliminated.

15. The method according to claim 1, wherein in (c), a part of the second film is modified to a fluorine- and oxygen-containing layer.

16. The method according to claim 1, wherein in (c), a part of the second film is modified to a silicon-, fluorine-, and oxygen-containing layer.

17. The method according to claim 1, wherein the etching agent is a substance containing at least one selected from the group of fluorine, chlorine, and iodine.

18. The method according to claim 1, wherein reactivity between the etching agent and the first film is lower than reactivity between the etching agent and the modified portion of the second film.

19. A method of manufacturing a semiconductor device, comprising:
(a) forming a first film in a concave portion by supplying a first film-forming agent to a substrate on a surface of which the concave portion is provided;
(b) forming a second film having a chemical composition different from a chemical composition of the first film on the first film formed in the concave portion by supplying a second film-forming agent to the substrate;
(c) modifying a part of the second film by supplying a modifying agent containing fluorine to the substrate; and
(d) removing a modified portion of the second film by supplying an etching agent containing halogen to the substrate.

20. A substrate processing apparatus comprising:
a processing chamber in which a substrate is processed;
a first film-forming agent supply system configured to supply a first film-forming agent to the substrate in the processing chamber;
a second film-forming agent supply system configured to supply a second film-forming agent to the substrate in the processing chamber;
a modifying agent supply system configured to supply a modifying agent containing fluorine to the substrate in the processing chamber;
an etching agent supply system configured to supply an etching agent containing halogen to the substrate in the processing chamber; and
a controller configured to be capable of controlling the first film-forming agent supply system, the second film-forming agent supply system, the modifying agent supply system, and the etching agent supply system to perform, in the processing chamber, a process comprising:
(a) forming a first film in a concave portion by supplying the first film-forming agent to the substrate on a surface of which the concave portion is provided,
(b) forming a second film having a chemical composition different from a chemical composition of the first film on the first film formed in the concave portion by supplying the second film-forming agent to the substrate,
(c) modifying a part of the second film by supplying the modifying agent to the substrate; and
(d) removing a modified portion of the second film by supplying the etching agent to the substrate.

21. A program that causes, by a computer, a substrate processing apparatus to execute a process comprising:
(a) forming a first film in a concave portion by supplying a first film-forming agent to a substrate on a surface of which the concave portion is provided;
(b) forming a second film having a chemical composition different from a chemical composition of the first film on the first film formed in the concave portion by supplying a second film-forming agent to the substrate;
(c) modifying a part of the second film by supplying a modifying agent containing fluorine to the substrate; and
(d) removing a modified portion of the second film by supplying an etching agent containing halogen to the substrate.
